(19) **Europäisches Patentamt**
**European Patent Office**
**Office européen des brevets**

(11) **EP 2 567 414 B1**

(12) **FASCICULE DE BREVET EUROPEEN**

(45) Date de publication et mention de la délivrance du brevet:
**18.03.2015 Bulletin 2015/12**

(21) Numéro de dépôt: **11724263.6**

(22) Date de dépôt: **03.05.2011**

(51) Int Cl.:
**H01L 35/32** *(2006.01)*

(86) Numéro de dépôt international:
**PCT/FR2011/000270**

(87) Numéro de publication internationale:
**WO 2011/138522 (10.11.2011 Gazette 2011/45)**

(54) **MODULE THERMOELECTRIQUE OPTIMISE POUR UN FONCTIONNEMENT EN MODE PELTIER OU EN MODE SEEBECK**

FÜR DEN BETRIEB IM PELTIER-MODUS ODER SEEBECK-MODUS OPTIMIERTES THERMOELEKTRISCHES MODUL

THERMOELECTRIC MODULE OPTIMIZED FOR OPERATION IN PELTIER MODE OR IN SEEBECK MODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2010 FR 1001929**

(43) Date de publication de la demande:
**13.03.2013 Bulletin 2013/11**

(73) Titulaire: **Commissariat à l'Énergie Atomique et aux Énergies Alternatives**
**75015 Paris (FR)**

(72) Inventeurs:
• **SAVELLI, Guillaume**
**F-38000 Grenoble (FR)**
• **CORONEL, Philippe**
**F-38530 Barraux (FR)**
• **PLISSONNIER, Marc**
**F-38320 Eybens (FR)**

(74) Mandataire: **Talbot, Alexandre et al**
**Cabinet Hecké**
**Europole**
**10, rue d'Arménie - BP 1537**
**38025 Grenoble Cedex 1 (FR)**

(56) Documents cités:
**WO-A1-2005/001946    WO-A2-96/15412**

**Description**

**Domaine technique de l'invention**

L'invention est relative à un module thermoélectrique comportant :

- un premier chemin électrique reliant une première entrée et une première sortie du module, et comprenant un premier ensemble de thermocouples reliés électriquement en série.

**État de la technique**

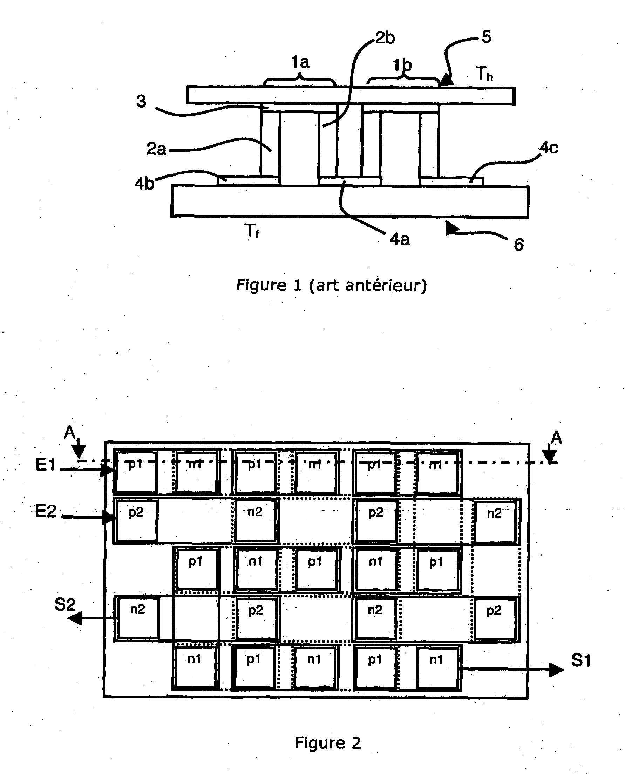

Une architecture classique d'un module thermoélectrique à deux thermocouples 1a, 1b est illustrée à la figure 1. Chaque thermocouple 1a, 1b comporte deux plots 2a, 2b reliés l'un à l'autre à l'une de leur extrémité par un élément de connexion électrique 3. Un premier plot 2a est, de préférence, formé dans un matériau de type P et un second plot 2b est, de préférence, formé dans un matériau de type N. Le module peut comporter une pluralité de thermocouples 1a, 1b tels que décrits ci-dessus mis en série et reliés entre eux par des connecteurs 4a métalliques pour optimiser le rendement du module. Des connecteurs métalliques 4b, 4c se trouvent aux extrémités de la série de thermocouples pour assurer les connexions électriques du module. Autrement dit, les thermocouples sont reliés électriquement en série et thermiquement en parallèle.

Le module thermoélectrique peut être utilisé soit en mode Seebeck, soit en mode Peltier. Il comporte un réservoir côté chaud 5 à température $T_h$ et un réservoir côté froid 6 à température $T_f$.

En mode Seebeck, le module produit de l'énergie à partir d'un gradient de température entre le côté chaud 5 et le côté froid 6. Ce mode est aussi appelé mode générateur de puissance.

En mode Peltier, l'application d'un courant aux bornes du module permet de générer un gradient de température entre le côté chaud 5 et le côté froid 6. Ce mode est aussi appelé mode refroidisseur.

En fait, le rendement du module thermoélectrique dépend des matériaux utilisés, de la géométrie du module, et de l'environnement d'utilisation. Ainsi, un module est soit optimisé pour le mode refroidisseur, soit optimisé pour le mode générateur de puissance, mais jamais pour les deux à la fois.

Le document WO-96/15412 décrit un module thermoélectrique comportant des thermocouples utilisant l'effet Peltier. Les thermocouples comportent chacun deux plots ayant des propriétés électriques et/ou des dimensions spécifiques et différentes. Les plots sont disposés en cascade, et sont reliés entre eux par un élément en matériau conducteur de manière à s'affranchir de moyens d'isolation entre les thermocouples de deux étages de la cascade.

Le document WO-2005/001946 décrit un module thermoélectrique à effet Peltier comportant au moins deux ensembles de thermocouples. Chaque ensemble de thermocouples comporte une entrée et une sortie. Les ensembles de thermocouples sont disposés l'un au-dessus de l'autre de manière à être séparés par une couche d'isolation.

**Résumé de l'invention**

L'objet de l'invention vise à réaliser un module thermoélectrique qui puisse être optimisé à la fois pour le mode générateur de puissance et pour le mode refroidisseur.

On tend vers cet objectif par les revendications annexées et notamment par le fait que chaque thermocouple du premier ensemble et du second ensemble comporte deux plots en matériau conducteur reliés électriquement entre eux, et en ce que ledit module comprend des moyens pour court-circuiter des plots du premier ensemble et ainsi former le second ensemble de thermocouples.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexées, dans lesquels :

La figure 1 illustre un module thermoélectrique à deux thermocouples selon l'art antérieur.
La figure 2 illustre, vu de dessus, un premier mode de réalisation d'un module thermoélectrique optimisé à la fois pour l'effet Peltier et pour l'effet Seebeck.
La figure 3 illustre la puissance générée par un module en mode Seebeck en fonction du nombre de thermocouples de ce module.
La figure 4 illustre la puissance en refroidissement générée par un module en mode Peltier en fonction du nombre de thermocouples de ce module.

La figure 5 illustre une vue en coupe selon A-A de la figure 2.

La figure 6 illustre une vue de dessus d'un module selon un second mode de réalisation.

Les figures 7 et 8 illustre une vue en coupe d'un module du type de celui de la figure 6, la figure 7 représentant le mode Peltier et la figure 8 représentant le mode Seebeck.

La figure 9 illustre une vue de dessus d'un module selon le second mode de réalisation lorsque celui-ci est optimisé Seebeck.

Les figures 10 à 24 illustrent différentes étapes de réalisation d'un module selon le second mode de réalisation.

**Description de modes préférentiels de réalisation**

Contrairement aux modules de l'art antérieur, le module thermoélectrique et ses modes de réalisation décrits ci-après permettent un fonctionnement optimal du module en mode Peltier et en mode Seebeck par l'utilisation de deux chemins électriques permettant de faire varier le nombre de thermocouples utilisés.

Par la suite, un thermocouple défini un élément comportant deux plots reliés électriquement entre eux, de préférence à l'une de leur extrémité, par un élément de connexion électriquement conducteur, et, de préférence, thermiquement conducteur. Les plots d'un même thermocouple sont, de préférence, formés dans deux matériaux différents, par exemple un matériau dopé P et un matériau dopé N. Il est possible d'utiliser des semi-métaux (Bi, Sb, etc.) ou des matériaux semiconducteurs dégénérés comme le Si, le SiGe. En fait, les matériaux utilisés seront fonction de l'environnement d'utilisation du module, ainsi, la personne de l'art sera capable de choisir le matériau convenant à une utilisation du module thermoélectrique.

De manière générale, un module thermoélectrique, par exemple comme celui illustré à la figure 2, peut comporter une pluralité de thermocouples. Un premier chemin électrique, reliant une première entrée E1 et une première sortie S1 du module, comprend un premier ensemble de thermocouples p1, n1 reliés électriquement en série, et un second chemin électrique, reliant une seconde entrée E2 et une seconde sortie S2 du module, comprend un second ensemble de thermocouples p2, n2 reliés électriquement en série. Le nombre de thermocouples du second ensemble est inférieur au nombre de thermocouples du premier ensemble.

Les entrées/sorties du module peuvent correspondre à deux bornes permettant de relier électriquement le module à un générateur de courant où à un accumulateur selon l'utilisation.

En fait, la variation du nombre de plots, et donc de thermocouples, permet de favoriser soit la puissance électrique générée (effet Seebeck) soit la puissance en froid du module (effet Peltier).

Autrement dit, en fonction des paramètres du module, le premier chemin peut former un module à effet Peltier, et le second chemin peut former un module à effet Seebeck. Le chemin associé Peltier n'est pas forcément plus long que le chemin Seebeck, ainsi, le premier chemin peut former un module à effet Seebeck, et le second chemin peut former un module à effet Peltier, tout dépend de la géométrie et des matériaux utilisés.

Dans un mode à effet Seebeck, l'objectif est d'obtenir le maximum de puissance électrique $Q_{gen}$, et dans un mode à effet Peltier, l'objectif est d'obtenir la plus grande puissance en froid $Q_{froid}$.

À titre d'exemple, il est possible de caractériser un module en tenant compte des paramètres définis ci-dessous dans la table I :

Table I

| Type | Paramètre | Variable | Valeurs |
|---|---|---|---|
| Paramètres thermiques | température réservoir chaud | $T_h$ | 350K |
| | température réservoir froid | $T_f$ | 300K |
| Paramètres matériaux | Coefficient Seebeck | S | 4,00E-04 V/K |
| | Conductivité thermique | $\lambda$ | 1,5W/m/K |
| | Résistivité électrique | $\rho$ | 1,60E-05Ω.m |
| | Conductivité thermique matrice | $\lambda_{air}$ | 0,026W/m/K |
| Paramètres géométrique | nombre de plots | n | VAR |
| | écart plot-bord du module | écart | 1,00E-04m |

(suite)

| Type | Paramètre | Variable | Valeurs |
|------|-----------|----------|---------|
| | longueur et épaisseur des plots | L | 4,00E-05m |
| | côté plots | b | 8,00E-06m |
| | surface des plots | $A_{np}$ | 6,40E-11m$^2$ |
| | espace entre deux plots | d | VAR en m |
| | surface du module | $A_{te}$ | 1,00E-04m$^2$ |
| Paramètres | surface du diffuseur thermique | $A_{hs}$ | 2,00E-04m$^2$ |
| d'échange thermique | coefficient de transfert de chaleur | h' | 1,00E+03W/m$^2$/K |
| Paramètres électriques | Résistance de contact | $R_c$ | 1,00E-11Ω.m$^2$ |
| | Résistance interne du module | $R_{int}$ | VAR en Ω |

Dans cette table, les paramètres thermiques définissent les températures aux bornes des thermocouples en Kelvin (avec côté chaud à $T_h$ et côté froid à $T_f$).

Les paramètres des matériaux définissent les caractéristiques des matériaux utilisés pour former les plots comme le coefficient Seebeck S, la conductivité thermique λ, la résistivité électrique ρ, et la conductivité thermique matrice $\lambda_{air}$ correspondant à la conductivité du matériau présent entre les plots (dans l'exemple il s'agit de l'air).

Les paramètres géométriques définissent le module par le nombre n de plots (avec n/2 étant égal au nombre de thermocouples), la hauteur L des plots, la section $A_{np}$ des plots définie dans le cas présent par un carré de côté b, l'espace d entre deux plots adjacents, la surface du module $A_{te}$ sur laquelle sont répartis les plots, et l'écart bord-plot séparant les plots les plus extérieurs du bord du module (pour des problématiques de réalisation technologique).

Les paramètres d'échange thermique avec l'environnement définissent la surface de d'échange thermique $A_{hs}$ entre le côté froid du module et l'environnement, et le coefficient de transfert de chaleur h entre le côté chaud du module et l'environnement, h peut par exemple être défini par de l'eau en convection forcée.

Les paramètres électriques définissent la résistance électrique de contact $R_c$ correspondant à la résistance électrique entre un plot et son élément de connexion, et la résistance interne $R_{int}$ correspondant à la résistance interne du module mesurée aux bornes de la série de thermocouples comprenant les résistances de contact et les résistances électriques des plots.

Avec de tels paramètres, la puissance électrique en mode Seebeck, et la puissance en refroidissement du mode Peltier peuvent s'écrire sous la forme d'équations. Les équations qui vont suivre sont basées sur un modèle prenant en compte les paramètres intervenants d'un point de vue électrique et thermique, ainsi que les paramètres liés à l'environnement dans lequel sera introduit le module. Bien que la température du côté froid soit à la température $T_f$, elle ne correspond pas réellement à la température froide du thermocouple, qui est en fait à une température $T_c$ supérieure à la température $T_f$. C'est donc la différence de température du module $T_h$-$T_c$ qui est prise en compte dans les équations et non la différence de température de l'environnement $T_h$-$T_f$.

Dans l'exemple particulier de réalisation qui va suivre, le matériau thermoélectrique utilisé est un matériau nanostructuré de type super réseau de boîtes quantiques QDSL (pour « Quantum Dots SuperLattices » en anglais) à base de nanoagrégats (« nanodots » en anglais) de germanium. Les différents plots sont séparés par de l'air, d'où la présence de $\lambda_{air}$.

Ainsi, la puissance électrique $Q_{gen}$ en mode Seebeck peut s'exprimer selon l'équation :

$$Q_{gen} = \frac{N^2 \times S^2 \times \left(T_h - T_c(N)\right)^2}{4R_{int}^2(N) \times A_{hs}} \quad (1)$$

Dans l'équation (1), $T_c$ est une inconnue et dépend de N, tout comme la résistance interne $R_{int}$, et N représente le nombre de thermocouples (N=n/2).

$R_{int}$ peut être définie selon l'équation :

$$R_{int}(L) = 2N \times \left( \frac{\rho \times L}{A_{np}} + \frac{2R_c}{A_{np}} \right) \quad (2)$$

Pour connaître l'expression de $T_c$, il faut écrire l'équation présentant le bilan des puissances entrant au niveau du module thermoélectrique avec la chaleur quittant le côté froid soit :

$$P_{Seeb} + P_{cond} + P_j = P_{hs} \quad (3)$$

où $P_{Seeb}$ représente l'effet Seebeck, $P_{cond}$ représente le transfert de chaleur par conduction, $P_j$ les pertes par effet Joule et $P_{hs}$ le transfert de chaleur par convection. Ces quatre termes font intervenir $T_c$, et aboutissent à la résolution de l'équation :

$$\left( \frac{2N \times \lambda \times \Delta T \times A_{np}}{L} + \frac{\lambda_{air} \times \Delta T \times (A_{te} - 2N \times A_{np})}{L} \right) + N \times S \times T_c \times I + \frac{1}{2} R_{int} \times I^2 = \left( T_c - T_f \right) h A_{hs}$$

$$(4)$$

où $\Delta T$ représente la différence de température entre $T_h$ et $T_c$, $\lambda_{air}$ la conductivité thermique de l'air, I le courant traversant les thermocouples.

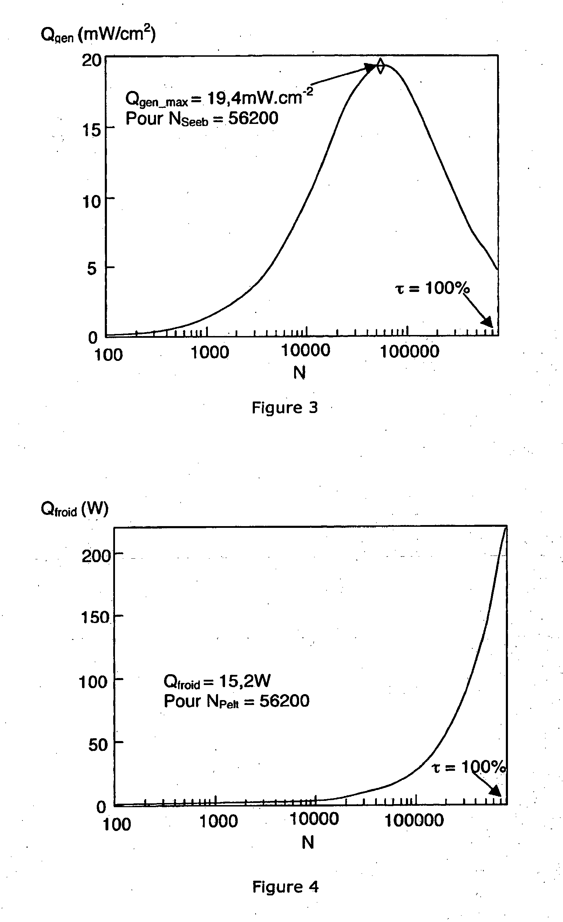

Cette équation (4) montre que $T_c$ est aussi fonction du paramètre N. Ainsi les équations (1) et (4) démontrent la dépendance de $Q_{gen}$ en fonction du nombre N de thermocouples. Selon les variables fixées dans la table I, la figure 3 illustre l'évolution de $Q_{gen}$ en fonction du nombre N de thermocouples, où $\tau$ représente le taux de remplissage des plots par rapport à la surface disponible. Sur cette figure 3, il est possible d'observer un point optimum $Q_{gen\_max}$ de 19,4mW.cm$^{-2}$ pour un nombre de thermocouples $N_{Seeb}$ de 56200.

Cette valeur $N_{Seeb}$ peut aussi être obtenue analytiquement en résolvant l'équation :

$$\left( \frac{\partial (Q_{gen})_{max}}{\partial L} \right)_{N=N_{Seeb}} = 0 = \left( \frac{\partial \left( \frac{N^2 \times S^2 \times (T_h - T_c(N))^2}{4 \times (R_{int}(N))^2 \times A_{hs}} \right)}{\partial N} \right)_{N=N_{Seeb}} \quad (5)$$

Des tests ont aussi été effectués pour le mode Peltier. En prenant en compte les effets Peltier, Joule et de la conduction thermique, la puissance en froid d'un module thermoélectrique favorisant l'effet Peltier peut s'écrire sous la forme:

$$Q_{froid} = N \times S \times I \times T_c(N) - \frac{1}{2} R_{int}(N) \times I(N)^2 - K(N) \times (T_h - T_c(N)) \quad (6)$$

Cette équation (6) fait aussi intervenir la variable N représentative du nombre de thermocouples, I le courant traversant la série de thermocouples, et où K(N) représente la conductance thermique totale définie par :

$$K(N) = \frac{2N \times \lambda \times A_{np}}{L} + \frac{\lambda_{air} \times (A_{te} - 2N \times A_{np})}{L} \qquad (7)$$

En application des équations (6) et (7), la figure 4 représente l'évolution de $Q_{froid}$ en fonction du nombre de thermocouples, où $\tau$ représente le taux de remplissage des plots par rapport à la surface disponible. Dans le cas présent, les paramètres d'entrée sont différents du mode Seebeck. Ainsi, un courant d'entrée égal à 10mA traverse la série de thermocouples. Dans ces conditions, un module ayant le même nombre de thermocouples que le module favorisant l'effet Seebeck génèrerait, comme illustré à la figure 4, une puissance de 15,2W. Cette valeur est loin d'être optimale, en effet, la figure 4 montre qu'en doublant le nombre de thermocouples (en passant de 56200 à 112400), il est possible d'obtenir dans les mêmes conditions 31W soit une augmentation d'environ 100% des performances.

Ceci justifie l'avantage particulier du module décrit qui peut s'adapter à la situation (fonctionnement en mode Seebeck ou en mode Peltier) en proposant des chemins électriques différents.

La démonstration décrite ci-dessus s'applique à deux modules distincts. En fait, la problématique d'intégrer deux chemins au sein d'un même module réside dans le fait qu'il faille, si l'on veut optimiser au mieux les deux effets, tenir compte du nombre de thermocouples au total $N_{tot}$ qui correspond à l'addition des thermocouples réservés pour le fonctionnement en mode Seebeck $N_{Seeb}$ et du nombre de thermocouples réservés pour le fonctionnement en mode Peltier $N_{pelt}$. En effet, si les premier et second chemins sont indépendants électriquement, tous les thermocouples sont néanmoins actifs thermiquement à cause du gradient de température entre le côté chaud et le côté froid du module.

Ainsi, dans les équations définies précédemment, il faut distinguer les thermocouples intervenant électriquement, des thermocouples intervenant thermiquement. Dès lors, dans le mode générateur (Seebeck) les équations (1) et (4) deviennent respectivement:

$$Q_{gen} = \frac{N_{Seeb}^2 \times S^2 \times \left(T_h - T_c(N_{tot}, N_{Seeb})\right)^2}{4 R_{int}^2(N_{Seeb}) \times A_{hs}} \quad (8)$$

et

$$\left(\frac{2N_{tot} \times \lambda \times \Delta T \times A_{np}}{L} + \frac{\lambda_{air} \times \Delta T \times (A_{te} - 2N \times A_{np})}{L}\right) + N_{Seeb} \times S \times T_c \times I + \frac{1}{2} R_{int}(N_{Seeb}) \times I^2 = \left(T_c - T_f\right) h A_{hs}$$

$$(9)$$

De même, en mode refroidisseur, les équations (6) et (7) deviennent respectivement :

$$Q_{froid} = N_{Pelt} \times S \times I \times T_c(N_{tot}, N_{Pelt}) - \frac{1}{2} R_{int}(N_{Pelt}) \times I^2 - K(N_{tot}) \times (T_h - T_c(N_{tot}, N_{Pelt}))$$

$$(10)$$

et

$$K(N_{tot}) = \frac{2N_{tot} \times \lambda \times A_{np}}{L} + \frac{\lambda_{air} \times (A_{te} - 2N_{tot} \times A_{np})}{L} \quad (11)$$

Dans ces quatre dernières équations, il apparaît qu'il faut, pour optimiser le module, prendre en compte le bon nombre de thermocouples correspondant soit à un terme électrique ($N_{Seeb}$ ou $N_{Pelt}$), soit à un terme thermique ($N_{tot}$).

Ainsi en fonction de la géométrie, les équations ci-dessus permettent d'optimiser au mieux le module pour les deux effets.

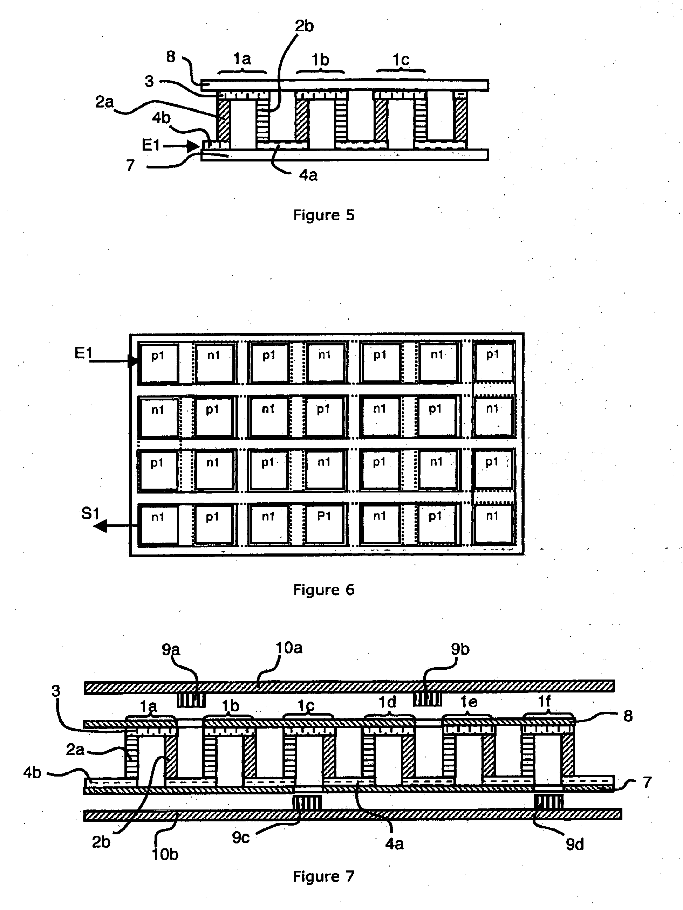

Dans un premier mode de réalisation, illustré aux figures 2 et 5, le module intègre deux chemins électriques distincts. Autrement dit, tes premier et second ensembles de thermocouples sont disjoints. Le premier chemin est optimisé pour, par exemple, favoriser l'effet Peltier, c'est-à-dire le fonctionnement en mode refroidissement du module. Ce premier chemin est défini par les premières entrée E1 et sortie S1, il comporte huit thermocouples reliés en série, soit seize plots, de préférence alternativement formés dans des matériaux différents, de sorte à former huit couples (p1, n1). Le second chemin est optimisé pour par exemple favoriser l'effet Seebeck, c'est-à-dire le fonctionnement en mode générateur de courant. Ce second chemin est défini par les secondes entrée E2 et sortie S2, il comporte quatre thermocouples reliés en série, soit huit plots p2, n2 formant quatre couples (p2, n2). Sur la figure 2, les première et secondes entrées sont distinctes et les première et seconde sorties sont distinctes.

Bien entendu, comme évoqué précédemment, le chemin optimisé Peltier n'est pas forcément plus long que le chemin Seebeck.

Ainsi, sur la figure 2, le choix de l'entrée E1 et de la sortie S1 déterminera l'utilisation du module par exemple en mode refroidissement, et le choix de l'entrée E2 et de la sortie S2 déterminera l'utilisation du module en mode générateur. Pour cela, il peut être possible de placer à l'entrée et à la sortie du module un sélecteur de type interrupteur pour relier l'une ou l'autre des entrées/sorties (E1, E2, S1, S2).

La figure 5 représente une vue en coupe selon A-A de la figure 2, on y retrouve, de préférence entre un support inférieur 7, formant par exemple le réservoir froid, et un support supérieur 8, formant par exemple le réservoir chaud, trois thermocouples 1a, 1 b, 1 c reliés en série par des connecteurs 4a. Chaque thermocouple comporte un premier plot 2a et un second plot 2b reliés l'un à l'autre par un élément de connexion 3, de préférence interposé entre les extrémités des plots et le support supérieur 8. Dans l'exemple de réalisation de la figure 5, les connecteurs 4a sont formés sur le support inférieur 7 et sont, de préférence interposés entre les plots associés et le support inférieur 7. Le premier plot 2a du premier thermocouple 1a peut être relié à un connecteur 4b faisant office d'entrée E1. Le plot situé à l'extrémité droite de la figure 5 constitue le premier plot du thermocouple suivant.

Selon une variante non représentée, les plots p1 et p2 au niveau des entrées E1 et E2 de la figure 2 sont reliés électriquement à leur base au niveau du support inférieur. Ainsi, le module comporte une seule entrée commune aux deux chemins et deux sorties distinctes. Dès lors, le simple choix de la sortie S1, S2 permet de sélectionner le mode de fonctionnement, par exemple en utilisant un interrupteur à deux états. Selon le même principe, il est aussi possible que le module comporte une seule sortie et deux entrées distinctes.

En appliquant les valeurs de la table I, les calculs, à partir des équations (8) à (11), montrent une optimisation du module pour un nombre de thermocouples optimisés Seebeck de 3134, et un nombre de thermocouples optimisés Peltier de 3899, soit au total 7033 thermocouples présents dans le module. En mode générateur, le module fournira une densité de puissance $Q_{gen}$ de 3,4 mW/cm2, et en mode refroidissement une puissance thermique $Q_{froid}$ de 0,03mW. Un tel module permet d'optimiser les deux fonctionnalités au sein du même module.

Le procédé de fabrication d'un module selon le premier mode de réalisation à deux chemins électriques distincts peut comporter, sur un substrat de base, le dépôt d'un film électriquement conducteur, puis la structuration de ce dernier de sorte à délimiter des connecteurs de type Seebeck et des connecteurs de type Peltier. Ensuite, un empilement en matériau thermoélectrique est déposé au-dessus des connecteurs Seebeck et Peltier. Un motif est formé au-dessus de l'empilement thermoélectrique de sorte à délimiter les différents plots qui seront associés aux thermocouples optimisés Seebeck et aux thermocouples optimisés Peltier. Ce motif est ensuite gravé jusqu'au substrat ou aux connecteurs Seebeck/Peltier. Les différents plots peuvent ensuite être noyés dans une couche électriquement isolante, puis cette couche électriquement isolante est aplanie, de sorte à laisser affleurer les extrémités libres des plots. Après formation des plots, ils peuvent être dopés de sorte à obtenir pour chaque chemin une alternance d'un premier et d'un second type de dopage (de préférence de type P et de type N) au niveau de chaque chemin.

Un second film électriquement conducteur est ensuite déposé sur l'empilement (au-dessus de la couche électriquement isolante et des extrémités libres des plots), puis gravé jusqu'à la couche isolante selon un motif supérieur permettant de délimiter les éléments de connexion entre les plots d'un même thermocouple. Ce motif supérieur comporte deux formes différentes, une forme destinée à la réalisation des éléments de connexion pour le chemin optimisé Seebeck et une autre forme destinée à la réalisation des éléments de connexion pour le chemin optimisé Peltier.

Dans un deuxième mode de réalisation illustré aux figures 6 à 9, les premier et second ensembles ont des éléments de thermocouples en commun. Autrement dit, le second chemin électrique est formé dans le premier chemin électrique, à partir d'éléments du premier chemin électrique. En fait, ces éléments de thermocouples peuvent être des plots, des éléments de connexion, des connecteurs.

Ainsi, chaque thermocouple du premier ensemble et du second ensemble comporte deux plots en matériau conducteur reliés électriquement entre eux, et ledit module comprend des moyens (9a, 9b, 9c, 9d) pour court-circuiter des plots du premier ensemble et ainsi former le second ensemble de thermocouples.

La figure 6 illustre, vu de dessus, un module thermoélectrique comportant quatorze thermocouples (p1, n1) formant une série de thermocouples définissant le premier chemin électrique, c'est-à-dire formant un module optimisé Peltier dans l'exemple de réalisation. Sur la figure 6, la série de thermocouples p1, n1 est formée de plusieurs rangées reliées entre elles en série au niveau de l'une de leurs extrémités.

Une vue en coupe, le long d'une rangée d'un module du type de celui de la figure 6 est illustrée à la figure 7.

Sur cette figure 7, les moyens de court-circuit sont, par exemple, constitués d'éléments électriquement conducteurs 9a, 9b, 9c, 9d, maintenus à distance des thermocouples du premier chemin dans un premier état du module.

Sur la figure 7, le module est optimisé par exemple Peltier, c'est-à-dire que tous les thermocouples sont actifs. La rangée comporte, dans le cas particulier de l'exemple, six thermocouples 1a, 1b, 1c, 1d, 1e, 1f, chaque thermocouple comporte un premier plot 2a, un second plot 2b reliés l'un à l'autre par un élément de connexion 3, de préférence interposé entre les extrémités des plots 2a, 2b et un support supérieur 8, formant par exemple le réservoir chaud. Dans l'exemple de réalisation de la figure 7, des connecteurs 4a sont formés sur un support inférieur 7, formant par exemple le réservoir froid, de sorte à relier en série les six thermocouples 1a, 1b, 1c, 1d, 1e, 1f. Ces connecteurs 4a sont, de préférence, interposés entre les plots associés et le support inférieur 7. Le premier plot 2a du premier thermocouple 1 a peut être, le cas échéant, relié à un connecteur 4b faisant alors office d'entrée E1. Les supports inférieur 7 et supérieur 8 sont percés à des endroits spécifiques pour permettre le passage des éléments conducteurs 9a, 9b, 9c, 9d destinés à mettre en court-circuit certains plots de thermocouples pour former de nouveaux thermocouples dans un second état du module, afin d'optimiser le module pour l'effet Seebeck.

Autrement dit, les éléments conducteurs sont en contact électrique avec des plots de thermocouples du premier chemin dans un second état du module de sorte à former le second chemin dans le premier chemin.

Dans ce mode de réalisation, la première entrée et la seconde entrée sont, de préférence communes et la première sortie et la seconde sortie sont, de préférence communes.

Sur la figure 7, les trous, au niveau du support supérieur 8, sont formés entre le second plot du premier thermocouple 1a et le premier plot du deuxième thermocouple 1b, et entre le second plot du quatrième thermocouple 1d et le premier plot du cinquième thermocouple 1e. Ces trous sont formés de sorte à laisser passer des éléments conducteurs 9a, 9b, pour relier directement des éléments de connexion de deux thermocouples adjacents entre eux. En outre, le support inférieur 7 comporte des trous formés entre le premier plot du troisième thermocouple 1c et le second plot du troisième thermocouple 1c, et entre le premier plot du cinquième thermocouple 1f et le second plot du cinquième thermocouple 1f. Ces trous inférieurs sont formés de sorte à laisser passer des éléments conducteurs 9c, 9d pour relier directement des connecteurs 4a d'un même thermocouple. Bien entendu, cet exemple particulier n'est qu'un mode de réalisation que la personne de l'art pourra modifier en fonction de la destination du module.

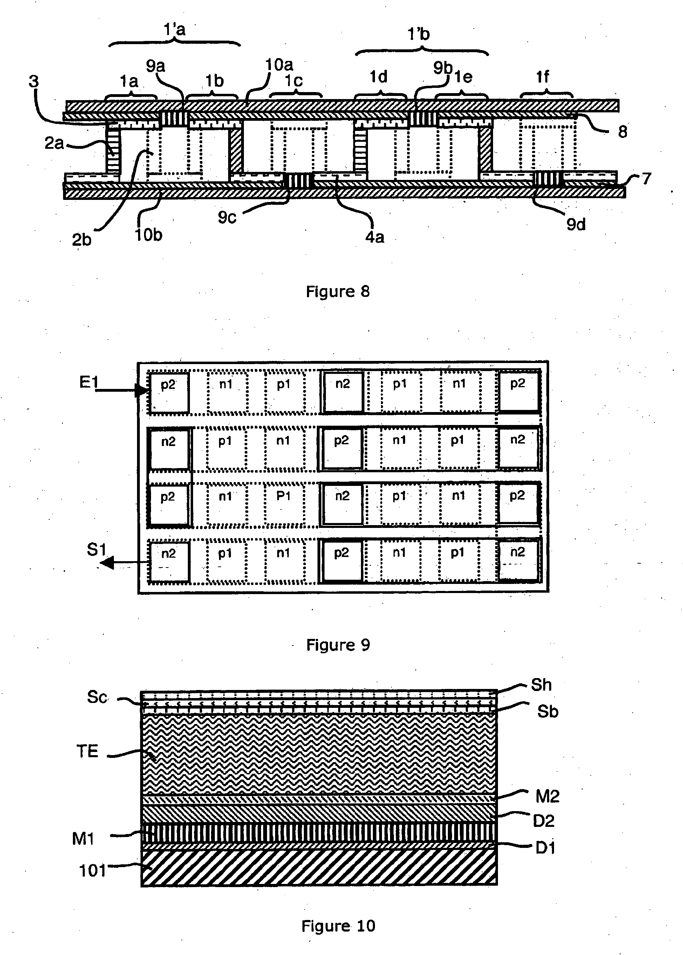

La figure 8 illustre la même vue en coupe du module de la figure 7, à la différence près que les éléments électriquement conducteurs 9a, 9b, 9c, 9d sont en position de court-circuit pour former un module par exemple optimisé Seebeck. Ainsi, la rangée ne comporte plus que deux thermocouples actifs $1'_a$ et $1'_b$ appelés dans l'exemple thermocouples Seebeck. Le premier thermocouple Seebeck $1'_a$ de la figure 8 est formé par le premier plot du premier thermocouple 1a de la rangée optimisée Peltier et le second plot du deuxième thermocouple 1b de la rangée optimisée Peltier. Ces deux plots sont alors reliés électriquement l'un à l'autre par l'élément de connexion du premier thermocouple 1a de la rangée optimisée Peltier, un premier élément électriquement conducteur 9a, et l'élément de connexion du deuxième thermocouple 1 b de la rangée optimisée Peltier.

Le deuxième thermocouple Seebeck $1'_b$ de la figure 8 est formé par le premier plot du quatrième thermocouple 1d de la rangée optimisée Peltier et le second plot du cinquième thermocouple 1e de la rangée optimisée Peltier. Ces deux plots sont reliés électriquement l'un à l'autre par l'élément de connexion du quatrième thermocouple 1d de la rangée optimisée Peltier, un deuxième élément électriquement conducteur 9b au niveau du support supérieur 8, et l'élément de connexion du cinquième thermocouple 1 e de la rangée optimisée Peltier. Les deux thermocouples Seebeck $1'_a$ et $1'_b$ sont reliés en série par deux connecteurs adjacents 4a mis en liaison électrique par un troisième élément électriquement conducteur 9c au niveau du support inférieur 7, sur la figure 8, cette mise en série est formée par le court-circuit du troisième thermocouple 1c de la rangée optimisée Peltier.

Le sixième thermocouple 1f de la rangée optimisée Peltier est rendu inactif par un quatrième élément conducteur 9d au niveau du support inférieur 7 pour terminer la nouvelle rangée optimisée Seebeck.

Sur la figure 8, les différents éléments de la figure 7 qui sont devenus inactifs sont représentés par des pointillés. Autrement dit, le module visible à la figure 6 ressemble, en mode Seebeck, au module de la figure 9 et ne comporte plus que six thermocouples actifs p2, n2 au lieu des quatorze initiaux, les plots p1 et n1 inactifs sont représentés en pointillés.

Sur l'exemple particulier des figures 7 et 8, les moyens de mise hors fonction comportent une première et une seconde plaque mobiles 10a, 10b respectivement supérieure et inférieure. Chaque plaque est équipée d'éléments conducteurs agencés de sorte que, lorsque les plaques 10a, 10b sont rapprochées du module, les éléments conducteurs 9a, 9b, 9c, 9d puissent venir mettre en court-circuit certains thermocouples pour en former de nouveaux.

Les première et seconde plaques 10a, 10b peuvent être respectivement sensiblement parallèles aux supports supérieur 8 et inférieur 7, et les éléments conducteurs respectivement associés à la première plaque 10a et à la seconde plaque 10b sont disposés sur ces dernières de sorte à être regard des trous associés percés dans les supports inférieurs 7 et supérieur 8. Autrement dit, les éléments conducteurs sont portés par les première et seconde plaques mobiles 10a, 10b disposées de part et d'autre des thermocouples, de préférence perpendiculairement aux plots de ces derniers.

Les première et seconde plaques 10a, 10b peuvent être mises en mouvement en utilisant des microsystèmes électromécaniques (MEMs). Les plaques peuvent par exemple être formées par des membranes aptes à se déplacer lors de l'application d'une stimulation.

La mise en court-circuit de certains thermocouples permet de former de nouveaux thermocouples plus espacés en utilisant des plots de thermocouples différents du premier chemin. À titre d'exemple, les moyens de mise hors fonction peuvent diviser par deux le nombre de thermocouples actifs du module lors du passage de mode optimisé Peltier au mode optimisé Seebeck.

Le second mode dé réalisation permet une amélioration du rendement et une diminution des effets parasites. Ainsi, un tel module pour un nombre total de thermocouples de 56200 fourni en mode Peltier une puissance en froid de 15,2W en utilisant tous les thermocouples, et en mode Seebeck une puissance de 9,7mW.cm$^{-2}$ pour un nombre de thermocouples de 28100. Les performances associées à ces deux modes sont excellentes, et permettent d'obtenir des performances équivalentes en refroidissement à un module uniquement optimisé Peltier et de fournir une densité de puissance toujours élevée en mode générateur.

Le procédé de fabrication du module selon le second mode de réalisation peut comporter, comme illustré à la figure 10, le dépôt successif sur un substrat de support 101 d'une première couche d'isolant électrique D1, d'une première couche électriquement conductrice M1, d'une deuxième couche d'isolant électrique D2, d'une deuxième couche électriquement conductrice M2, d'une couche en matériau thermoélectrique TE, d'une couche sacrificielle basse Sb, d'une couche sacrificielle centrale Sc et d'une couche sacrificielle haute Sh.

L'empilement ainsi obtenu va être utilisé pour former la partie basse du module thermoélectrique.

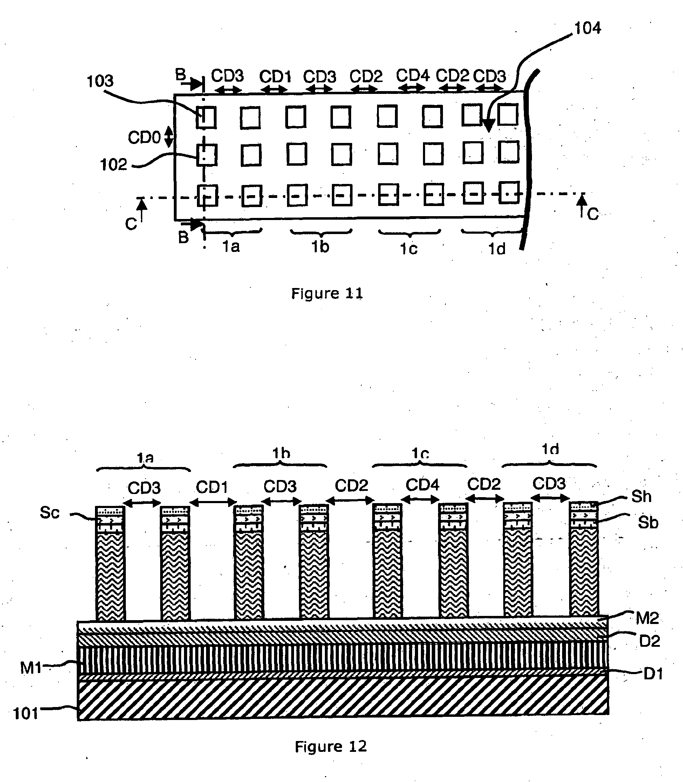

Tout d'abord, un motif est formé sur l'empilement de sorte à délimiter dés plots. La figure 11 illustre une vue de dessus de l'empilement sur lequel est formé un motif 102 destiné à délimiter trois rangées de huit plots 103. Ensuite, l'empilement est gravé selon le motif 102 jusqu'à la deuxième couche électriquement conductrice M2 comme sur la figure 12 qui est une vue en coupe selon C-C de la figure 11. Sur l'exemple particulier des figures 11 et 12, chaque rangée va comporter quatre thermocouples 1a, 1b, 1c, 1 d reliés en série de façon à optimiser, de préférence, l'effet Peltier. De préférence, deux plots adjacents d'une même rangée sont en matériaux différents, par exemple des plots alternativement dopés p et n. Le matériau thermoélectrique peut être dopé, par exemple par implantation ionique, juste après l'étape de gravure selon le motif 102.

Sur la figure 11, l'espace inter-rangée est défini par une distance CD0, qui correspond en fait à la distance minimum entre deux plots se faisant face de deux rangées adjacentes. Sur les figures 11 et 12, de gauche à droite et au niveau de chaque rangée, le premier thermocouple 1a comporte deux plots espacés d'une distance CD3, puis le premier thermocouple 1 a est séparé de du deuxième thermocouple 1b par une distance CD1, le deuxième thermocouple 1b comporte deux plots espacés d'une distance CD3, le deuxième thermocouple 1b est séparé du troisième thermocouple 1c par une distance CD2, le troisième thermocouple 1c comporte deux plots espacés d'une distance CD4 et le troisième thermocouple 1c est séparé du quatrième thermocouple 1d par une distance CD2, puis le cycle se répète si les rangées comportent plus de quatre thermocouples, sur la figure le quatrième thermocouple comporte deux plots séparés par une distance CD3. Afin de faciliter l'auto-alignement lors de la fabrication, on a CD0>CD4>CD3>CD2>CD1, soit une succession de distances large et étroite. Bien entendu, le module suivant peut aussi être réalisé avec des distances entre deux plots adjacents d'une même rangée quelconque, dès lors on pourra utiliser des étapes de photolithographie et de gravure classiques, mais qui ne faciliteront pas l'auto-alignement. Après gravure selon le motif 102, chacune des distances définies ci-dessus délimitent des espaces vides séparant les différents plots et rangées.

Après gravure jusqu'à la deuxième couche électriquement conductrice M2 l'espace entre deux rangées (de dimension transversale CD0) est comblé par un matériau sacrificiel inter-rangée 104. Ce matériau inter-rangée est formé de manière à combler l'espace entre deux rangées défini par CD0. Ainsi, le matériau inter-rangée forme une barre en contact avec tous les plots de deux rangées adjacentes au niveau de parois latérales des plots des deux rangées se faisant face. Autrement dit, après dépôt du matériau inter-rangée 104 on obtient pour chaque plot deux parois latérales opposées recouvertes par le matériau inter-rangée et deux autres parois latérales libres. Il est possible de combler les espaces inter-rangées en deux temps, dans un premier temps un dépôt conforme d'un matériau vient combler tous les espaces à l'exception des espaces inter-rangées qui restent ouverts. Une gravure vient ensuite retirer le matériau déposé conforme au niveau des inter-rangées uniquement, puis dans un second temps le matériau inter-rangée est déposé. Cette méthode utilisant le dépôt conforme implique que CD0 soit supérieur aux distances CD1, CD2, CD3, CD4. Une autre méthode consiste à déposer directement le matériau inter-rangée, puis à retirer sélectivement ce dernier par photolithographie suivie d'une gravure, de sorte à n'en laisser qu'au niveau des espaces inter-rangées.

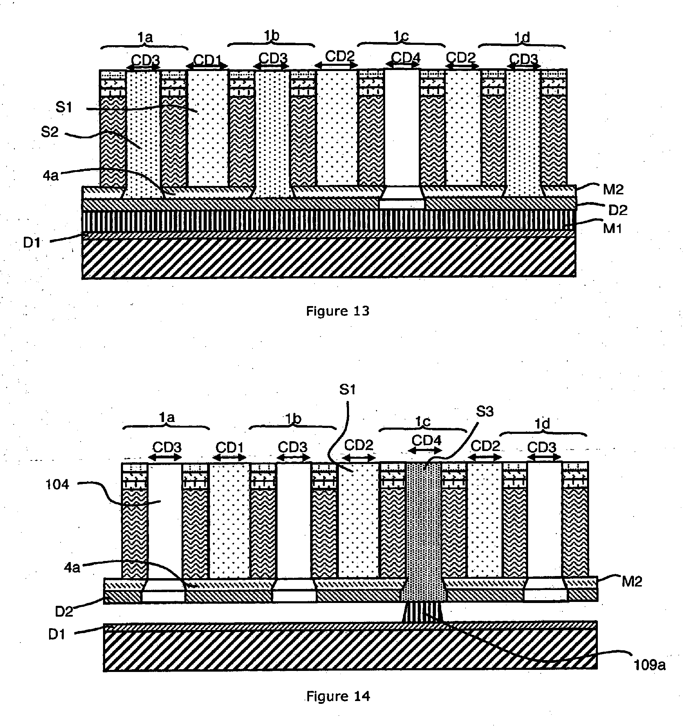

Sur la figure 13, après localisation du matériau inter-rangée, l'espace entre deux thermocouples 1a, 1b, 1c, 1d adjacents est rempli par un premier matériau sacrificiel S1. Autrement dit, on obtient une alternance zone vide/plot/zone pleine/plot. Dans le cas particulier de l'autoalignement, les espaces définis par les distances CD1 et CD2 de la figure 12 sont comblés par le premier matériau sacrificiel S1. Ce remplissage peut être effectué sélectivement par dépôt conforme puis gravure, dès lors la distance séparant deux plots d'un même thermocouple est supérieure à la distance séparant deux thermocouples adjacents (CD3 et CD4 sont supérieurs à CD1 et CD2). Sinon, il est aussi possible de faire un dépôt suivi d'une étape de photolithographie et de gravure pour combler uniquement les espaces définis par les distances CD1 et CD2.

Ensuite, dans les zones libres (c'est-à-dire au niveau des espaces définis par CD3 et CD4), la deuxième couche électriquement conductrice M2 est gravée jusqu'à affleurement de la deuxième couche isolante D2, de préférence avec une gravure isotrope permettant une gravure latérale comme sur la figure 13 de la deuxième couche électriquement conductrice M2. Ceci permet de façonner les différents connecteurs 4a.

Après gravure de la deuxième couche électriquement conductrice M2, les espaces entre les plots des thermocouples 1a, 1b, 1d sont comblés par un deuxième matériau sacrificiel S2. Autrement dit, à la figure 13 il n'existe qu'un seul espace entre deux plots qui soit ouvert, cet espace étant celui défini par la distance CD4. Le deuxième matériaux sacrificiel S2 peut être localisé par dépôt conforme suivi d'une gravure, dès lors, la distance CD3 est inférieure à la distance CD4 de sorte à laisser l'espace défini par CD4 ouvert. Bien entendu, il est aussi possible de faire un dépôt du deuxième matériau S2 sacrificiel suivi d'une étape de photolithographie et de gravure pour ne laisser ouvert que CD4.

Après dépôt du deuxième matériau sacrificiel S2, la deuxième couche isolante D2 est gravée de manière anisotrope jusqu'à la première couche électriquement conductrice M1 (figure 13).

Sur la figure 14, consécutivement à la gravure de la deuxième couche isolante D2 l'espace entre les plots du troisième thermocouple 1c, c'est-à-dire la zone vide existante définie par la distance CD4, est comblé par un troisième matériau sacrificiel S3. Ensuite, le second matériau sacrificiel S2 est retiré sélectivement pour rendre accessible la deuxième couche isolante D2 au niveau des espaces définis par les distances CD3, c'est-à-dire entre les deux plots du thermocouple 1 a, les deux plots du thermocouple 1b et les deux plots du thermocouple 1d. A ce moment-là, la deuxième couche isolante D2 est retirée sélectivement jusqu'à la première couche électriquement conductrice M1.

Ainsi, la première couche électriquement conductrice M1 est accessible via les espaces définis par les distances CD3. Cette couche électriquement conductrice M1 est ensuite attaquée par gravure isotrope jusqu'à délimiter les éléments électriquement conducteurs 109a, sous la forme de saillies, au niveau de chaque espace défini par CD4.

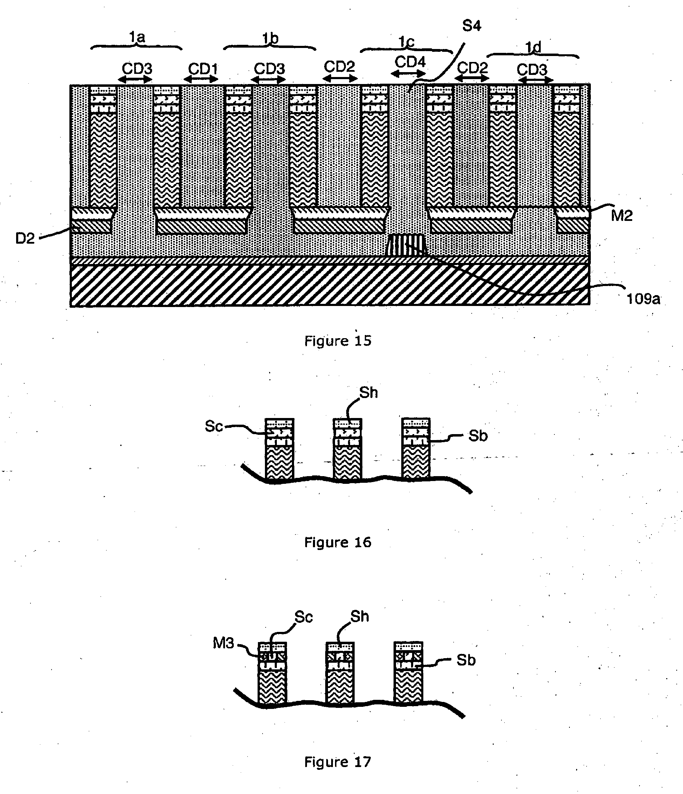

Après formation de l'élément conducteur 109a, au niveau de chaque rangée, tous les matériaux sacrificiels à l'exception du matériau inter-rangée sont supprimés c'est-à-dire les matériaux S1 et S3 restant, puis les zones vides sont comblées par un quatrième matériau sacrificiel S4 comme illustré à la figure 15. Bien entendu, il est aussi possible de laisser en place les matériaux sacrificiels S1 et S3 et de combler les espaces avec le quatrième matériau S4. Le dépôt du quatrième matériau sacrificiel S4 peut être suivi d'un aplanissement de la structure jusqu'à affleurement du reste de la couche sacrificielle haute Sh. Le quatrième matériau sacrificiel S4 peut aussi être déposé de sorte à combler au moins les espaces entre les différents plots de manière à former un film continu affleurant au niveau de la couche sacrificielle haute Sh, et se terminant sous le niveau de la couche sacrificielle basse Sb.

La partie basse du module est à présent terminée, reste à prévoir les connexions en partie haute.

La figure 16 illustre une vue en coupe selon B-B de la figure 11 après formation de la partie basse et retrait du matériau inter-rangée au niveau de toutes les rangées pour atteindre les faces latérales de la couche sacrificielle centrale Sc.

La figure 17 illustre le résultat obtenu après gravure sélective partielle, par exemple, par gravure isotrope, de la couche sacrificielle centrale Sc au niveau de chaque plot, une troisième couche en matériau électriquement conducteur M3 étant déposée de sorte à combler le vide créé par la gravure sélective partielle. On obtient alors deux motifs électriquement conducteurs encastrés sur deux faces opposées au niveau de chaque plot.

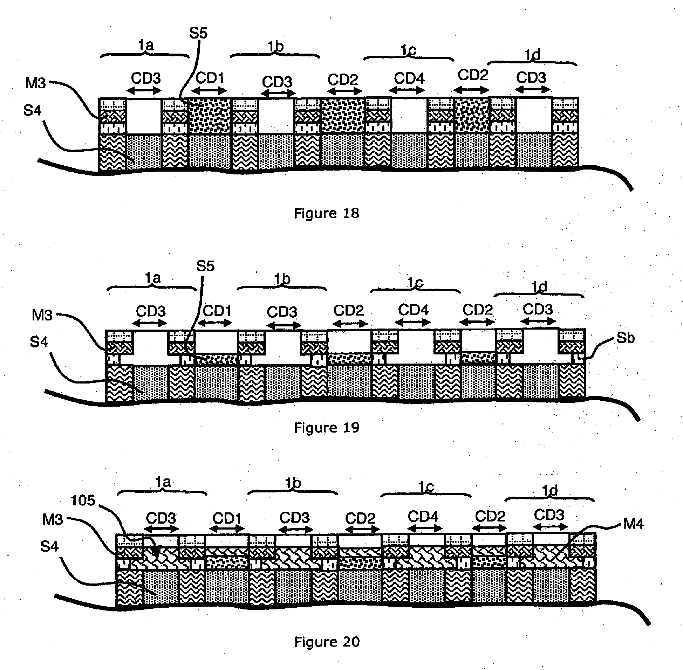

Les espaces inter-rangées sont ensuite à nouveau comblés par un matériau inter-rangée (qui peut être le même que celui précédemment déposé), et le quatrième matériau sacrificiel S4 est retiré sélectivement entre chaque plot jusqu'au niveau de la partie basse de la couche sacrificielle basse Sb, comme l'illustre la figure 18 (vue en coupe selon C-C de la figure 11), de sorte à libérer les faces latérales de la couche sacrificielle basse Sb. Après retrait partiel du quatrième matériau sacrificiel S4, un cinquième matériau sacrificiel S5 est déposé de sorte à ne combler que les espaces définis au niveau des distances CD1 et CD2, c'est-à-dire entre les premier et deuxième thermocouples 1a, 1 b, entre les deuxième et troisième thermocouples 1 b, 1c, et entre les troisième et quatrième thermocouples 1 c, 1 d à la figure 18. Ceci peut être obtenu comme précédemment par dépôt suivi de photolithographie puis gravure, ou dépôt conforme puis gravure (CD3 et CD4 étant supérieurs à CD1 et CD2).

Après dépôt du cinquième matériau sacrificiel S5, la couche sacrificielle basse Sb est gravée partiellement de manière isotrope, puis le cinquième matériau sacrificiel S5 est retiré jusqu'à la partie basse de la couche sacrificielle centrale, c'est-à-dire la partie basse de la couche M3 comme illustré à la figure 19.

Une quatrième couche électriquement conductrice M4 est ensuite déposée, ce dépôt est suivi d'un aplanissement jusqu'à affleurement du matériau inter-rangée, puis d'un retrait de la quatrième couche électriquement conductrice M4 jusqu'à la partie haute de la couche sacrificielle centrale Sc, selon la vue de coupe de la figure 20 cela correspond à la partie haute de la troisième couche électriquement conductrice M3. À ce moment, les éléments de connexion 105 des thermocouples 1 a, 1 b, 1 c, 1 d ont été formés au niveau des espaces définis par les distances CD3 et CD4.

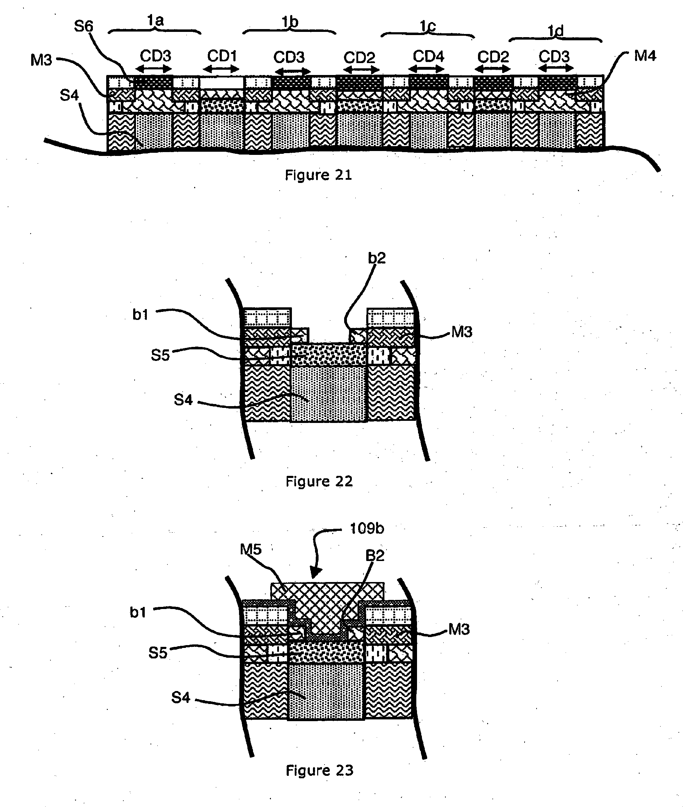

Ensuite, (figure 21) les espaces laissés libres sont comblés par un sixième matériau sacrificiel S6 à l'exception de l'espace défini par la distance CD1, c'est-à-dire entre le premier thermocouple 1a et le second thermocouple 1b, de sorte à permettre la formation à ce niveau d'un élément conducteur.

Sur la figure 22 qui est un agrandissement de la figure 21 au niveau de l'espace CD1, après dépôt du sixième matériau sacrificiel S6, la quatrième couche électriquement conductrice M4 peut être gravée sélectivement jusqu'à la cinquième couche sacrificielle S5 de sorte à former deux barres b1, b2 sensiblement parallèles entre elles, chacune des barres étant en contact avec une portion opposée, au niveau de deux plots distincts adacents, de la couche électriquement conductrice M3 au niveau de l'espace CD1. L'empilement est ensuite aplani en retirant partiellement le sixième matériau sacrificiel S6 et la couche sacrificielle supérieure Sh, mais en gardant la hauteur initiale du matériau inter-rangée 104 (figure 23). Une septième couche sacrificielle S7 est ensuite déposée, son épaisseur est sensiblement égale à celle du retrait partiel de la couche sacrificielle supérieure Sh. Ensuite, comme illustré à la figure 23, une cinquième couche électriquement conductrice M5 est ensuite déposée de sorte à délimiter localement un élément conducteur 109b au niveau de l'espace défini par CD1. Une membrane est alors formée au-dessus de l'empilement, l'élément 109b ainsi formé par la couche M5 étant fixé à la membrane.

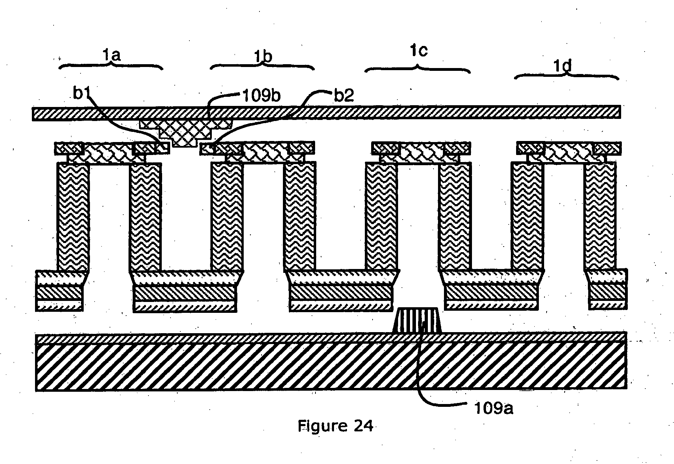

Pour finir, les couches sacrificielles basse Sb, centrale Sc, hautes, Sh, les matériaux sacrificiels S4, S5, S6 sont retirés pour obtenir le module selon la figure 24 formé par quatre thermocouples 1a, 1b, 1c, 1d reliés en séries. Par ailleurs, le reste de la couche métallique M4 est retiré sélectivement au niveau des espaces définis par CD2 de sorte à éviter la mise en court-circuit du deuxième thermocouple 1 b avec le troisième thermocouple 1 c et du troisième 1 c thermocouple avec le quatrième thermocouple 1d.

Sur la figure 24, un premier élément conducteur 109a est apte à se déplacer pour venir mettre en contact électrique le second plot dru premier thermocouple 1a avec le premier plot du deuxième, thermocouple 1b, et un second élément conducteur 109a est apte à se déplacer pour venir mettre en contact électrique le premier plot du troisième thermocouple 1c avec le second plot du troisième thermocouple 1c, c'est-à-dire court-circuiter le thermocouple 1c.

## Revendications

1. Module thermoélectrique comportant :

   - un premier chemin électrique, reliant une première entrée (E1) et une première sortie du module (S1), et comprenant un premier ensemble de thermocouples (p1,n1) reliés électriquement en série,
   - un second chemin électrique reliant une seconde entrée (E2) et une seconde sortie (S2) du module, et comprenant un second ensemble de thermocouples (p2, n2) reliés électriquement en série, le nombre de thermocouples du second ensemble étant inférieur au nombre de thermocouples du premier ensemble.

   module **caractérisé en ce que** chaque thermocouple du premier ensemble et du second ensemble comporte deux plots en matériau conducteur reliés électriquement entre eux, et **en ce que** ledit module comprend des moyens (9a, 9b, 9c, 9d) pour court-circuiter des plots du premier ensemble et ainsi former le second ensemble de thermocouples.

2. Module selon la revendication 1, **caractérisé en ce que** les moyens de court-circuit comportent des éléments (9a, 9b, 9c, 9d) électriquement conducteurs maintenus à distance des thermocouples du premier chemin dans un premier état du module et en contact électrique avec des plots de thermocouples du premier chemin dans un second état du module.

3. Module selon la revendication 2, **caractérisé en ce que** les éléments conducteurs (9a, 9b, 9c, 9d) sont portés par des première et seconde plaques mobiles (10a, 10b) disposées de part et d'autre des thermocouples.

4. Module selon la revendication 1, **caractérisé en ce que** l'un des chemins (E1, 81) forme un module à effet Peltier, et l'autre chemin (E2, S2) forme un module à effet Seebeck.

5. Module selon la revendication 1, **caractérisé en ce que** la première entrée (E1) et la seconde entrée (E2) sont communes et **en ce que** la première sortie (S1) et la seconde sortie (S2) sont communes.

## Patentansprüche

1. Thermoelektrisches Modul mit:

   - einem ersten elektrischen Pfad, der einen ersten Eingang (E1) und einen ersten Ausgang des Moduls (S1) verbindet und eine erste Einheit von Thermoelementen (p1, n1) umfasst, die elektrisch in Reihe geschaltet sind,

- einem zweiten elektrischen Pfad, der einen zweiten Eingang (E2) und einen zweiten Ausgang (S2) des Moduls verbindet und eine zweite Einheit von Thermoelementen (p2, n2) umfasst, die elektrisch in Reihe geschaltet sind, wobei die Anzahl der Thermoelemente der zweiten Einheit niedriger als die Anzahl der Thermoelemente der ersten Einheit ist,

wobei das Modul **dadurch gekennzeichnet ist, dass** jedes Thermoelement der ersten Einheit und der zweiten Einheit zwei Stöpsel aus leitendem Material aufweist, die elektrisch miteinander verbunden sind, und dass dieses Modul Mittel (9a, 9b, 9c, 9d) zum Kurzschließen der Stöpsel der ersten Einheit und somit zur Bildung der zweiten Einheit von Thermoelementen umfasst.

2. Modul gemäß Anspruch 1, **dadurch gekennzeichnet, dass** die Kurzschlussmittel elektrisch leitende Elemente (9a, 9b, 9c, 9d) aufweisen, die in einem ersten Zustand des Moduls in einem Abstand von den Thermoelementen des ersten Pfades und in einem zweiten Zustand des Moduls in elektrischem Kontakt mit den Stöpseln der Thermoelemente des ersten Pfades gehalten werden.

3. Modul gemäß Anspruch 2, **dadurch gekennzeichnet, dass** die leitenden Elemente (9a, 9b, 9c, 9d) von ersten und zweiten beweglichen Platten (10a, 10b) getragen werden, die auf beiden Seiten der Thermoelemente angebracht sind.

4. Modul gemäß Anspruch 1, **dadurch gekennzeichnet, dass** einer der Pfade (E1, S1) ein Modul mit Peltier-Effekt bildet und der andere Pfad (E2, S2) ein Modul mit Seebeck-Effekt bildet.

5. Modul gemäß Anspruch 1, **dadurch gekennzeichnet, dass** der erste Eingang (E1) und der zweite Eingang (E2) gemeinsame Eingänge sind und dass der erste Ausgang (S1) und der zweite Ausgang (S2) gemeinsame Ausgänge sind.


**Claims**

1. A thermoelectric module comprising:

 - a first electric path connecting a first input (E1) and a first output (S1) of the module, and comprising a first set of thermocouples (p1,n1) electrically connected in series,
 - a second electric path connecting a second input (E2) and a second output (S2) of the module, and comprising a second set of thermocouples (p2, n2) electrically connected in series, the number of thermocouples of the second set being smaller than the number of thermocouples of the first set,

 a module **characterized in that** each thermocouple of the first set and of the second set comprises two legs made from conducting material, electrically connected to one another, and **in that** said module comprises means (9a, 9b, 9c, 9d) for short-circuiting legs of the first set so as to form the second set of thermocouples.

2. The module according to claim 1, **characterized in that** the means for short-circuiting comprise electrically conducting elements (9a, 9b, 9c, 9d) maintained at a distance from the thermocouples of the first path in a first state of the module and in electric contact with legs of thermocouples of the first path in a second state of the module.

3. The module according to claim 2, **characterized in that** the conducting elements (9a, 9b, 9c, 9d) are supported by first and second movable plates (10a, 10b) arranged on each side of the thermocouples.

4. The module according to claim 1, **characterized in that** one of the paths (E1, S1) forms a Peltier effect module and the other path (E2, S2) forms a Seebeck effect module.

5. The module according to claim 1, **characterized in that** the first input (E1) and the second input (E2) are common and **in that** the first output (S1) and the second output (S2) are common.

Figure 1 (art antérieur)

Figure 2

$Q_{gen}$ (mW/cm$^2$)

$Q_{gen\_max} = 19,4mW.cm^{-2}$
Pour $N_{Seeb} = 56200$

$\tau = 100\%$

N

Figure 3

$Q_{froid}$ (W)

$Q_{froid} = 15,2W$
Pour $N_{Pelt} = 56200$

$\tau = 100\%$

N

Figure 4

Figure 5

Figure 6

Figure 7

Figure 8

Figure 9

Figure 10

Figure 11

Figure 12

Figure 13

Figure 14

Figure 15

Figure 16

Figure 17

Figure 18

Figure 19

Figure 20

20

Figure 21

Figure 22

Figure 23

Figure 24

**RÉFÉRENCES CITÉES DANS LA DESCRIPTION**

**Documents brevets cités dans la description**

- WO 9615412 A
- WO 2005001946 A